# EUROPEAN PATENT APPLICATION

(11) **EP 2 804 209 A1**
(43) Date of publication of application: **19.11.2014**
(21) Application number: 13168251.0
(22) Date of filing: 17.05.2013
(51) Int. Cl.: H01L 23/495, H01L 21/56, H01L 25/07

(54) **Moulded electronics module**

(71) Applicant: ABB Technology AG, 8050 Zürich (CH)
(72) Inventor: Brem, Franziska, 8700 Küsnacht (CH); Liu, Chunlei, 5406 Rütihof (CH); Hartmann, Samuel, 5603 Staufen (CH); Schnell, Raffael, 5703 Seon (CH); Duran, Hamit, 5300 Turgi (CH)
(74) Representative: ABB Patent Attorneys

(57) **Abstract**

A method for producing an electronics module (44, 44', 44") comprises the steps of: bonding a semiconductor device (12) to a first substrate (10); moulding the semiconductor device (12) and the first substrate (10) into a moulding material (32), such that the semiconductor device (12) and the first substrate (10) are at least partially covered by the moulding material (32) and such that the moulding material (32) comprises an opening (34) to a bonding area (20) of the semiconductor device (12); positioning a second substrate (46) opposite to the first substrate (10) with respect to the semiconductor device (10); and bonding the second substrate (46) to the bonding area (20) of the semiconductor device (12).

## Description

### Field of the invention

The invention relates to packaging of electronic components. In particular, the invention relates to a method producing an electronics module and to an electronics module.

### Background of the invention

Classic packaging technologies such as aluminium (Al) wire bonding are considered as the limiting factor for better performance of power electronics modules and packages. Further, new applications require different outer module dimensions and more compact design of power electronics modules.

Planar emitter contacts are a step towards these new design requirements. The main general trend of actual IGBT module manufacturers is eliminating the wire bonded contacts implementing new solutions replacing the aluminium wires.

Conventionally, the assembly of an electronics module starts by bonding a semiconductor chip to a substrate (for example a metallized ceramic substrate such as ceramic substrates with direct bonded copper or direct bonded aluminium) or to a lead frame in a first step. The bonding may be done by sintering, soldering, transient liquid phase bonding or gluing depending on the module requirements and classification. A second step of electrical connecting an emitter side of the chip is then traditionally performed by wire bonding.

As already mentioned, one possible bonding technique for chip bonding, but also other interconnections in power electronic modules is sintering. Ag sintering is known for a while, however, the implementation of this technology at module manufacturers' production is still ongoing and the application is mainly based on die bonding.

Sintering has one main process challenge: As pressures up to 10 MPa are necessary for achieving a low porosity in the sinter connection, softer parts in the assembly like emitter contacts may be difficult to sinter as they bend along the underlying topology of the substrate and the chip.

Furthermore, to lower costs, fully moulded modules targeting a certain product range of voltage and current rating come to market.

### Description of the invention

Objects of the invention are facilitating the assembly of electronics modules, enhancing the robustness and the reliability of bonding connections of electronics modules and lowering cost in the production of electronics modules.

These objects are achieved by the subject-matter of the independent claims. Further exemplary embodiments are evident from the dependent claims and the following description.

An aspect of the invention relates to a method for producing an electronics module. The electronics module or package may comprise at least one chip with two planar opposite contact areas that also may be seen as bonding areas that are bonded to an upper and a lower substrate.

According to an embodiment of the invention, the method comprises the steps of: bonding a semiconductor device to a first substrate; moulding the semiconductor device and the first substrate into a moulding material, such that the semiconductor device and the first substrate are at least partially covered by the moulding material and such that the moulding material comprises an opening to a bonding area of the semiconductor device; positioning a second substrate opposite to the first substrate with respect to the semiconductor device; and bonding the second substrate to the bonding area of the semiconductor device.

It may be seen as a gist of the invention that in a first moulding step, an opening is formed through which the bonding may take place in a second step. Such, the moulding used for assembling, protecting and/or isolating the electronics module facilitates the bonding of the second side of the electronics module.

The semiconductor device may be an electronics chip, for example a high power chip. The semiconductor device may be a (high power) IGBT, transistor or diode with two planar bonding areas on opposite sides. The bonding areas may be active areas or electrical contacts of the semiconductor device. For example, the bonding area facing the first substrate may be a collector contact and the bonding area facing the second substrate may be an emitter contact.

During the bonding, a mechanically stable electrical connection is formed between the bonding area of the semiconductor device and the respective substrate.

The moulding results in an opening above the bonding area of the semiconductor device. The opening may be seen as a window through which the bonding area may be accessed for bonding after the moulding.

The moulding material may be formed (for example in a press) such that after the bonding no or nearly no cavities are left between the second substrate and the semiconductor device and/or the first substrate. The interior of the electronics module may be completely filled with the material of the semiconductor device, the moulding material and the bonding material.

The moulding material may be a resin compound, for example an epoxy resin. For example, the moulding may be performed by resin transfer moulding.

It may be possible that the moulding material is first formed in a press or mould tool and after that is post-cured treated for completely hardening the moulding material.

According to an embodiment of the invention, the method further comprises the step of: protecting the bonding area of the semiconductor device with a plastics film before the moulding. The method may be a film assisted moulding method. For example, the film may be a PTFE film. After the moulding, the plastics film may be removed.

According to an embodiment of the invention, the method further comprises the step of: applying a bonding material into the opening before the bonding of the second substrate. The bonding material may be applied in the form of a paste or an adhesive.

According to an embodiment of the invention, the bonding material is a sintering material and the bonding of the second substrate is performed by sintering the second substrate to the semiconductor device. For example, the bonding material may comprise Ag particles or Ag nano particles. The sintering may be performed by applying a high pressure to the second substrate and/or by heating the sintering material. Also pressure less sinter pastes are possible.

In the case of an IGBT or transistor, an emitter contact may be window moulded through the opening and after that, the planar emitter contact may be sintered.

Ag sintering may provide a robust and reliable connection. Usually, a planar structure is used for applying the necessary sintering pressures without deforming the side of the semiconductor device carrying the bonding area, for example the top emitter contact. The combination with a moulding step, which results in an opening above the bonding area, may facilitates the sintering step.

The combination of an Ag sintering process providing very reliable connections with an encapsulation method may provide a simple and cheap solution for the manufacturing of a (power) electronics module. Furthermore, due to the already present moulding material, the semiconductor device may be sintered without a deformation of the substrate (which may be a relative thin lead frame).

According to an embodiment of the invention, the bonding material is a soldering material and bonding of the further substrate is performed by soldering the further substrate to the semiconductor device. In the case of an IGBT or transistor, the emitter contact may be window moulded and after that, the planar emitter contact may be soldered. Also other interconnection technologies may be used for bonding the emitter contact. The soldering may take place in a furnace or by induction heating.

According to an embodiment of the invention, the moulding material forms a frame around the opening, such that the opening forms a deepening for receiving the bonding material. The extension of the opening and of the frame may be smaller than the planar side of the semiconductor device facing the second substrate. For example, the opening may be a substantially rectangular deepening. The opening may have a bevelled frame and/or bevelled edges. The height of the frame or the height of the opening may determine the thickness of the applied bonding material, i.e. it may be possible to fill the opening with bonding material such that the surface of the bonding material is flush with the moulding material.

According to an embodiment of the invention, the moulding material covers the semiconductor device such that dedicated areas of the semiconductor device cannot come into contact with bonding material during the bonding of the semiconductor device to the substrate. In such a way, a moulding step before the bonding step may protect dedicated areas of the semiconductor device.

According to an embodiment of the invention, the first and/or second substrate is a lead frame, PCB, flex print or metallized ceramic. In particular, the first substrate may be a lead frame or a PCB and the second substrate may be a metallised ceramic.

According to an embodiment of the invention, the method further comprises the step of: soldering or sintering the semiconductor device to the first substrate. The bonding of the semiconductor device to the first substrate (before the moulding) may be performed by a soldering or sintering step. Also this sintering step may be based on Ag (nano) particle sintering.

In general, the semiconductor device may comprise a further bonding area that is bonded to the first substrate. The bonding areas/active areas of the semiconductor device may be on opposite sides of the semiconductor device, may be planar areas and/or may be substantially parallel.

According to an embodiment of the invention, the method further comprises the step of: attaching an electrically conducting metal plate and/or applying a metallic layer to the bonding area of the semiconductor device. The metal plate may provide an electrically conduction spacer between the semiconductor device and the substrate (for example for enhancing the isolation (clearance distance) between the semiconductor device and the substrate). The metal plate may be made of Al.

The metal plate may be attached (bonded) to the semiconductor device before the moulding. In this case, the semiconductor device, the first substrate and the metal plate may be moulded into the moulding material, such that the moulding material has an opening providing a bonding area on the metal plate for bonding the second substrate to the metal plate.

The metal plate may be attached (bonded) to the semiconductor device after the moulding. In this case, the metal plate may be positioned in the opening after the moulding. The metal plate and the opening may conform to each other, such that there is no or nearly no distance between the metal plate and the inner wall of the opening.

According to an embodiment of the invention, the method further comprises the step of: electrically connecting the semiconductor device to the first substrate via a wire bond. The wire bond may be encased into the moulding material during the moulding. For example, only a gate contact may be a wire bond. The semiconductor device may also comprise a gate contact on the side facing the second substrate. This gate contact may be connected by a wire bond to the first substrate before the moulding. After that, the wire bond may be completely covered with moulding material and may be protected and insulated via this material.

According to an embodiment of the invention, a plurality of semiconductor devices is attached to the (substantially planar) first substrate, moulded into one moulding material and the second substrate is bonded to the plurality of semiconductor devices. The semiconductor devices may be sandwiched between the first and the second substrate. The mould material may cover the semiconductor devices and the first substrate such that it provides a substantially planar surface (except the openings), onto which the second substrate may be positioned before the bonding.

According to an embodiment of the invention, the method further comprises the step of: structuring the second substrate such that the second substrate has a protrusion fitting into the opening in the moulding material. The protrusion may conform to the opening, for example may have bevelled edges, too. To form the protrusion, the second substrate may be pressed and/or etched.

Summarized, the method may be seen as an assembly process for a resin moulded package with a robust bonded emitter contact. This may result in a compact electronics module combined with an encapsulation of the components of the electronics module. A sintering of the electric contacts of the semiconductor device (at the bonding areas of the semiconductor device) may be performed one after the other such that the sintering may be executed on a mostly planar structure.

A further aspect of the invention relates to an electronics module. It has to be understood that features of the method as described in the above and in the following may be features of the electronics module as described in the above and in the following and vice versa.

According to an embodiment of the invention, the electronics module comprises an electronics semiconductor device; a first substrate, wherein the semiconductor device is bonded with a first side to the first substrate; a moulding material, wherein the semiconductor device and the first substrate are moulded into the moulding material, such that the semiconductor device and the first substrate are at least partially covered with cured moulding material and such that the cured moulding material comprises an opening to a bonding area of the semiconductor device; and a second substrate, wherein the second substrate is positioned opposite to the first substrate with respect to the semiconductor device and bonded through the opening in the moulding material to a second side of the semiconductor device.

For example, moulding material may be situated between the semiconductor device and the second substrate, when the semiconductor device and the first substrate are moulded before the bonding of the second substrate. Furthermore, only the first substrate may stick to the moulding material, if only the first substrate and the semiconductor device have been moulded together. The electronics module may be fully moulded and may comprise bonded stable connections providing low inductance and low thermal resistance.

It is also possible that the moulding material is only between the first and the second substrate. In such a way, it is possible that the electronics module provides two substantially planar outer surfaces, which are surfaces of the two substrates and which may be used for cooling and/or for electrically connecting the electronics module. The semiconductor devices and the moulding material may be sandwiched between the two substrates. Double side cooling or insulated modules are both possible.

In general, due to the two planar substantially substrates, also the electronics module may be a planar module.

With such an electronics module, silicone gel encapsulation as well as the outer housing may be replaced by a single resin moulding encapsulation. This may provide compactness of the module and may eliminate silicone gel filling.

These and other aspects of the invention will be apparent from and elucidated with reference to the embodiments described hereinafter.

### Brief description of the drawings

The subject matter of the invention will be explained in more detail in the following text with reference to exemplary embodiments which are illustrated in the attached drawings.
Fig. 1 schematically shows a cross-sectional view of components of an electronics module according to an embodiment of the invention in a mould tool.
Fig. 2 schematically shows a cross-sectional view of components of an electronics module according to another embodiment of the invention in a mould tool.
Fig. 3 schematically shows a cross-sectional view of the components of Fig. 1 in the closed mould tool.
Fig. 4 schematically shows a cross-sectional view of the components of Fig. 3 after moulding.
Fig. 5 schematically shows a cross-sectional view of the components of Fig. 4 being prepared for bonding.
Fig. 6 schematically shows a cross-sectional view of the components of Fig. 5 applied with bonding material.
Fig. 7 schematically shows a cross-sectional view of an electronics module according to an embodiment of the invention during sintering.
Fig. 8 schematically shows a cross-sectional view of an electronics module according to an embodiment of the invention during soldering.
Fig. 9 shows a cross-sectional view of a structured lead frame for an electronics module according to an embodiment of the invention.
Fig. 10 shows a cross-sectional view of another structured lead frame for an electronics module according to an embodiment of the invention.
Fig. 11 schematically shows a top view on components of an electronics module according to an embodiment of the invention.
Fig. 12 schematically shows a top view on an electronics module according to an embodiment of the invention.
Fig. 13 schematically shows a cross-sectional view of the electronics module of Fig. 13.
Fig. 14 schematically shows a top view on components of an electronics module according to an embodiment of the invention.
Fig. 15 schematically shows a cross-sectional view of an electronics module according to an embodiment of the invention.
Fig. 16 schematically shows a cross-sectional view of an electronics module according to an embodiment of the invention.
Fig. 17 schematically shows a cross-sectional view of an electronics module according to an embodiment of the invention.

In principle, identical parts are provided with the same reference symbols in the figures.

### Detailed description of exemplary embodiments

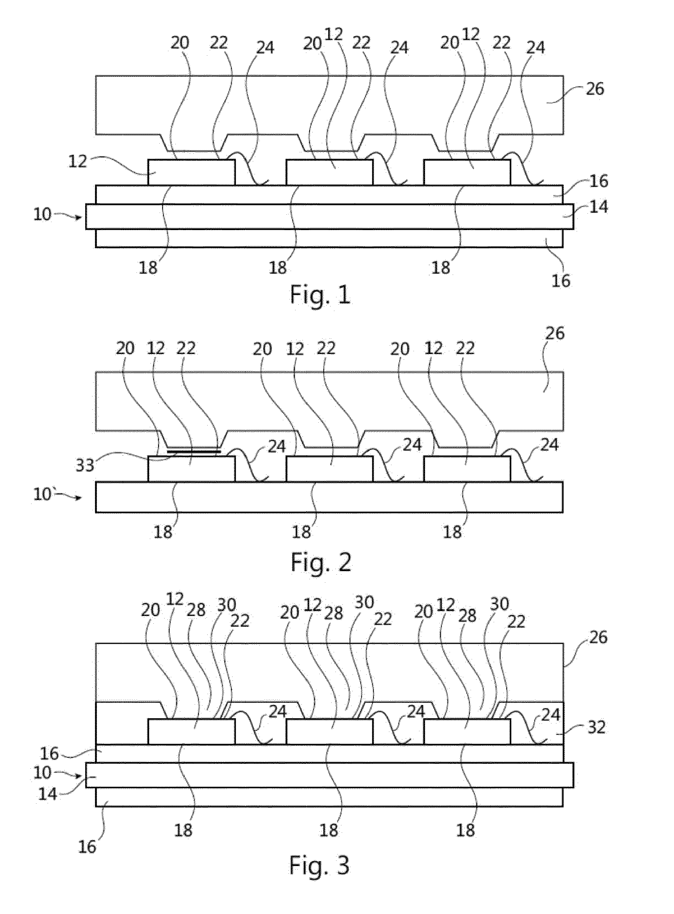

Steps of a method for producing an electronics module are shown in Fig. 1 to Fig. 10.

Fig. 1 schematically shows a cross-sectional view of components of an electronics module, in particular a substantially planar first substrate 10 with semiconductor devices 12 in the form of chips 12 bonded to one side. The first substrate 10 comprises an insulator 14 (for example ceramics) with two conductive metallization layers 16 on its sides. For example, the metallization layers 16 are copper (Cu) or aluminium (Al) layers.

The semiconductor devices 12 have bonding areas 18, 20 on each side, which may be substantially parallel and/or may be substantially planar.

The semiconductor devices 12 have been bonded to the first substrate 10, i.e. to the metallization layer 16 with a first bonding area 18. For example, the semiconductor devices 12 may have been soldered or sintered or bonded by transient liquid phase bonding to the first substrate 10.

If the semiconductor devices 12 are IGBTs, it is possible that they have an additional bonding area 22, for example at the side with the bonding area 20. In this case, the bonding area 18 may provide a collector, the bonding area 20 an emitter and the bonding area 22 a gate of the IGBT 12. The first substrate 10 and in particular the metallization layer 16 may be structured and may provide contacts for the collectors and gates.

The semiconductor devices 12 have been connected to the first substrate 10 via a (thin) wire bond 24, for example to the respective contacts of the metallization layer 16.

After that, the semiconductor devices 12 on the ceramic substrate 10 have been placed into a mould tool 26, as it is shown in Fig. 1.

Fig. 2 schematically shows a cross-sectional view of components of an electronics module according to an alternative embodiment. In Fig. 2, the first substrate 10 is a lead frame (for example plated Cu).

Fig. 3 schematically shows the components of Fig. 1 in the closed mould tool 26. The mould tool 26 has protrusions 28 with a planar head 30.

The mould tool 26 has been closed and the mould tool 26 has been placed with its head 30 on the bonding areas 20 of the semiconductor devices 12.

After that, a moulding material 32 (for example an epoxy) is transferred into the mould tool 26 and the semiconductor devices 12 and the first substrate 10 are moulded into the moulding material 32.

To protect the semiconductor devices 12, the moulding step may be performed by film assisted moulding, where e.g. a PTFE film is used to protect the semiconductor devices 12. For example, a PTFE film 33 may be placed between the head 30 and the bonding area 20 (see Fig. 2).

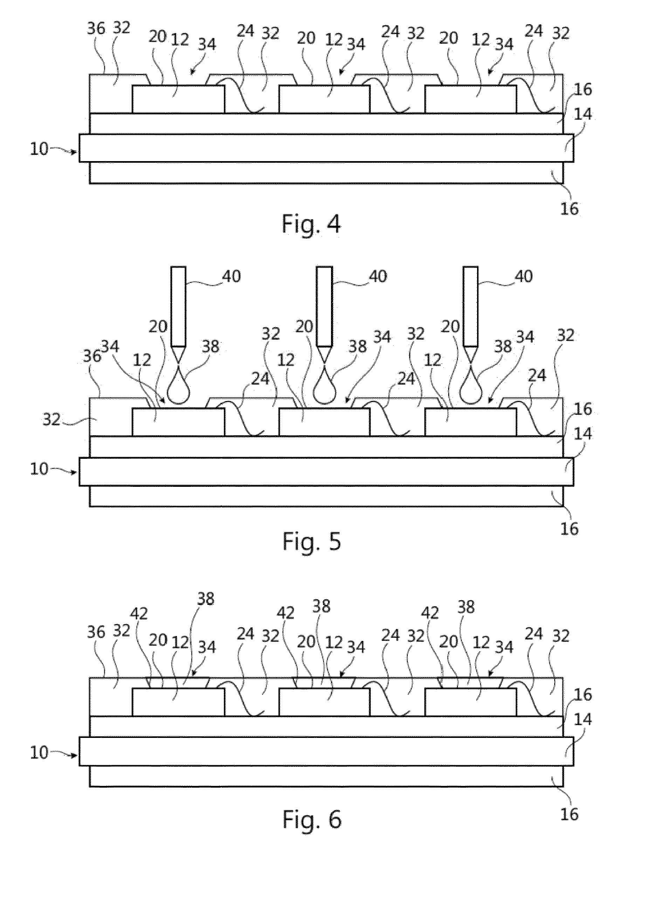

Fig. 4 shows the components of Fig. 3 after moulding. The semiconductor devices 12 and the first substrate 10 are at least partially covered by the moulding material 32 and the hardened moulding material 32 comprises opening 34 above the bonding areas 20. Also the wire bonds are encased into the moulding material 30.

The outer surface 36 of the moulding material 32 may be substantially planar except the openings 34 to the bonding areas 20.

After the moulding, a post-cure process may be performed for a final cross linking of the moulding material 32, which may be an epoxy matrix.

Fig. 5 shows the components of Fig. 4 being prepared for bonding.

A bonding material 38 is applied into the openings 34. The bonding material may be a liquid or a paste and may be applied with a dispensing device 40. However, it is also possible that the bonding material 38 is applied by putting a film or a sheet into the openings 34.

The moulding material 32 forms a frame 42 around the bonding areas 20, such that unwanted areas of the semiconductor device are not contaminated with the bonding material.

The bonding material 38 may be a sintering material, for example a sintering paste or a sintering adhesive. Alternatively, the bonding material 38 may be a soldering material, such as a soldering paste.

Fig. 6 shows the components of Fig. 5 with the applied bonding material 38. The dispensed bonding material 38 is distributed in the openings 34.

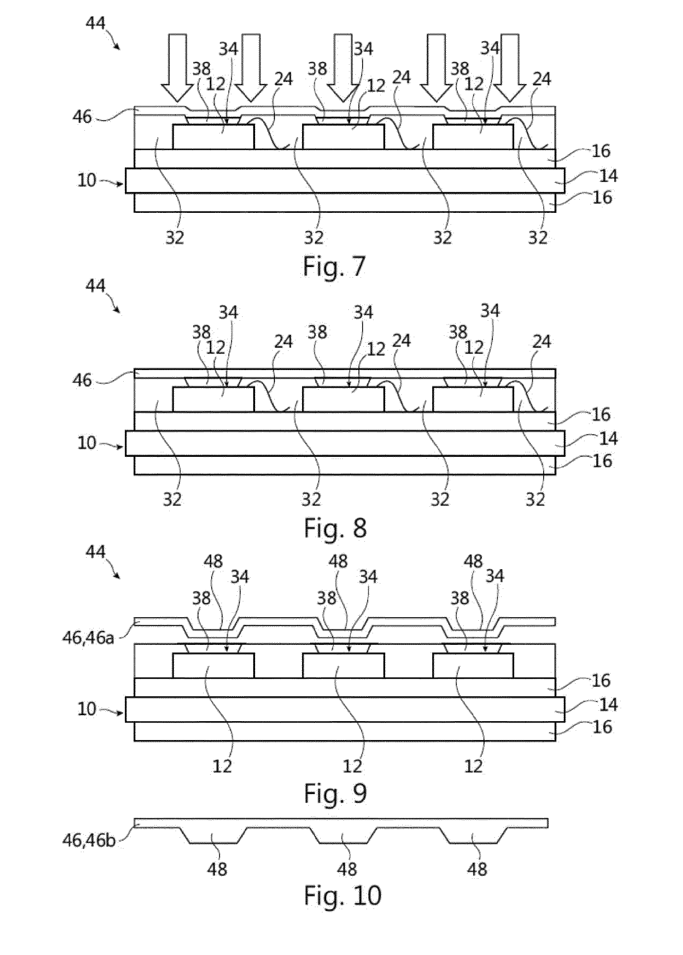

Fig. 7 shows an electronics module 44 during sintering. The electronics module is formed by positioning a second substrate 46 opposite to the first substrate 10 with respect to the semiconductor devices 12. In such a way, the semiconductor devices 12 are sandwiched between the two substrates 10, 46.

For example, as shown in Fig. 7, the second substrate 46 may be a lead frame and in the case of IGBTs 12 may provide a planar emitter contact. Alternatively, the second substrate 46 may be a PCB or Flex print.

The bonding of the second substrate 46 may be performed by sintering the second substrate to the semiconductor device. During sintering, a high pressure and heat may be applied to the electronics module 44, such that the sintering material 38 bonds the semiconductor devices 12 to the second substrate 46. Due to the high pressure, a slight deformation of the lead frame 46 is possible due to the compression of the sintering material 38.

Additionally it is possible to glue the second substrate 46 to the moulding material 32. For example, an adhesive tape may be laminated to contact areas between the lead frame 46 and the moulding material, in order to prevent any air gaps.

As shown in Fig 8, also other bonding methods are possible. Fig. 8 shows an electronics module 44 with a second substrate 46 (a lead frame, PCB, Flex print etc.) soldered to the semiconductor devices 12. In this case, less pressure (a slight fixation pressure for example) is needed (and the lead frame is not deformed). The soldering may be performed with reflow soldering, where a solder paste 38 is dispensed (see Fig. 5).

The above embodiments may be used for voltage applications up to 3.3 kV. For applications with even higher voltages (for example 6.5 kV), a structured lead frame may be used that increases the insulation distance.

As shown in Fig. 9 and 10, the second substrate 46 may be structured such that it has protrusions 48 fitting into the openings 34 in the moulding material 32. The protrusions 48 may have bevelled edges. Also, the openings 34 may have bevelled edges.

Fig. 9 shows that a lead frame 46a may be made of a pre-shaped metal sheet. The protrusions may compensate for the shrink of the bonding material 38.

Fig. 10 shows a lead frame 46b, that for example has been etched to generate the protrusions 48. The lead frame 46b has an increased thickness where it touches the bonding area 20 of the semiconductor devices 12.

Summarized, the method is based on two principle assembly steps:

In a first assembly step, a first substrate 10 equipped with semiconductor devices 12 is moulded, leaving an opening 34 on the bonding area 20 of the semiconductor devices 12.

In a second assembly step, a second substrate 46 is bonded to the bonding areas of the semiconductor devices 12 through the opening 34. In the case of sintering and IGBTs or analogous semiconductor devices 12, the second substrate 46 may be an emitter contact which is sintered with a sintering paste or adhesive or soldered to the bonding area 20 on the semiconductor 12.

As may be seen from Fig. 7 to Fig. 9, a substrate 10, 46 is provided on both sides of the module 44, the moulding material may be only inside of the module 44. In such a way, a double side cooling is possible for the module 44.

As shown in Fig. 9, no wire bonds 24 are necessary at all. For example, a gate bond may be integrated in the lead frame 46 or may be integrated on a flex print emitter contact.

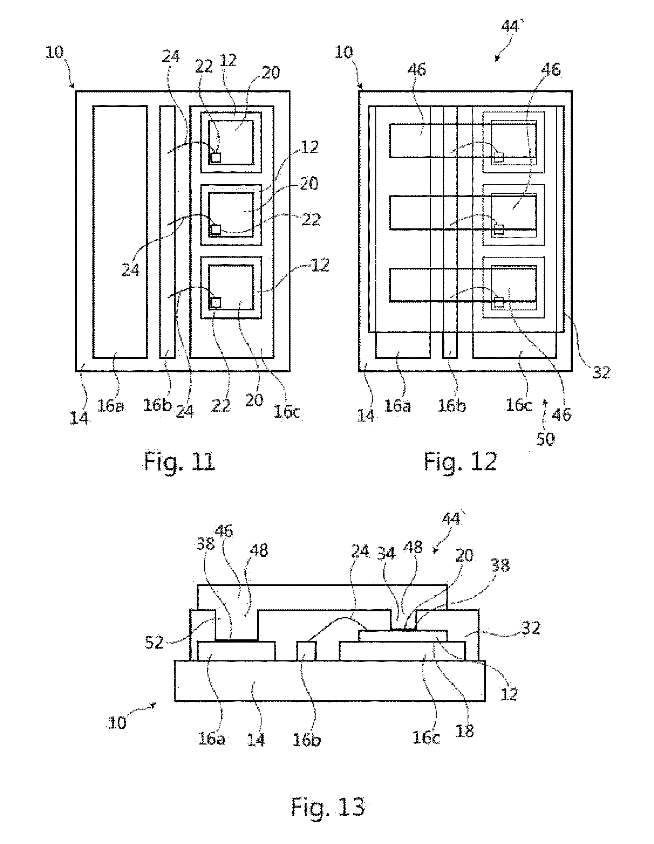

Fig. 11 to 13 show a further embodiment of an electronics module 44' that may be manufactured with the above described method and that may have a target voltage between 1.2 kV to 1.7 kV.

As shown in Fig. 11, the first substrate 10 may comprise insulating ceramics 14 with a metallization providing an emitter contact 16a, a gate contact 16b and a collector contact 16c. In general, possible substrates 10 may comprise insulating ceramics, for example AlN, Al2O3, a PCB or a lead frame with an insulating film such as e.g. KTM (Nippon Kayaku).

Each of the semiconductor devices 12 may be a chip with an IGBT, which is bonded with its bonding area 18 to the collector contact 16c as described above. The chips 12 may be mounted by soldering or sintering to the first substrate 10. Furthermore, the bonding areas 22 for the gate may be wire bonded to the gate contact 16b.

As shown in Fig. 12 and 13, after bonding to the first substrate 10, the chips 12 are moulded into moulding material 32. The moulding material 32 covers the contacts 16a, 16b, 16c except a contact area 50 on one side of the module 44' and openings 52 above the emitter contact 16a. Furthermore, the moulding material 32 covers the chips 12 except openings 34 above the bonding area 20 for the emitter. Such the electronics module 44' is electrically insulated in this area. The insulation to the other side may be provided by a ceramic.

After that, a bonding material 38 may be placed into the openings 34, 52 as described above and the emitter contact 16a is electrically connected to the bonding areas 20 and the emitter contact 16a by bonding a lead frame 46 as described in the above. For example, lead frame 46 may be sintered or soldered to the emitter contact 16 and the bonding area 20.

The openings 34, 52 may have edges that are substantially orthogonal to the outer surface of the moulding material 32 and/or the bonding areas 20.

Further connections to gate contact 16b, emitter contact 16a and collector contact 16c may be provided by ultrasonic welding of terminals, soldering, wire bonding, press contacts, solder pins, or screw contacts.

The benefits of the electronics module 44' may be: reliability of robust emitter contact, a semi-hermetic package, low inductance, double side cooling is possible and parallelizing by contacting several modules to one cooler plate.

For enhanced cooling, also a full plate instead of single "ribbon"-type lead frames 46 is possible.

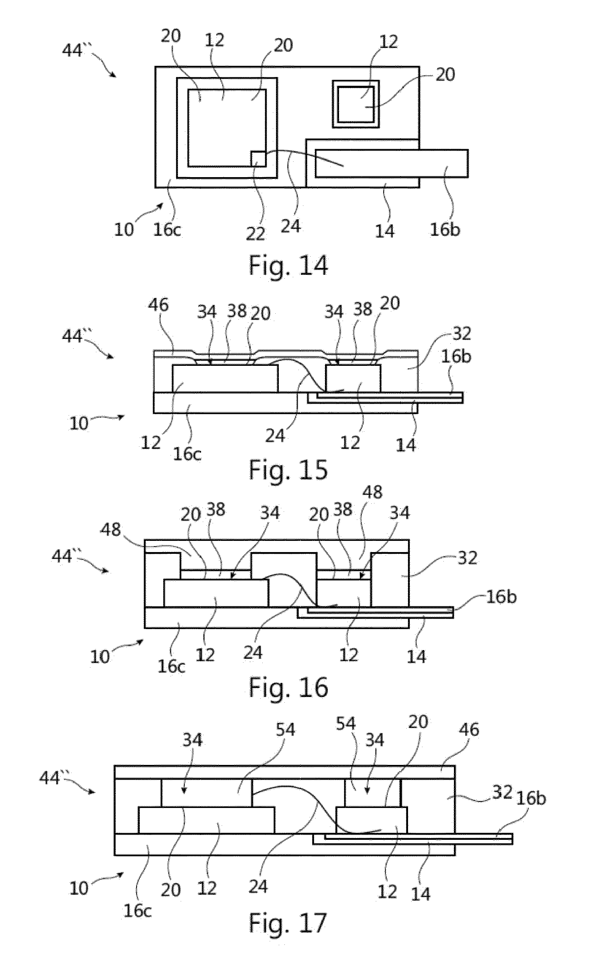

Fig. 14 to 17 show a further embodiment of an electronics module 44" that may be manufactured with the above described method.

The electronics module 44' comprises two chips 12 (for example an IGBT and a diode) that are bonded to a conducting first substrate 10, for example a lead frame 16c with an insulated gate contact 16b, which may comprise ceramics 14 as insulation. The gate contact 16b may be a track in the ceramics 14. The two chips 12 may be soldered or sintered to the first substrate 10, i.e. the lead frame 16c.

The gate of the IGBT may be connected with a flat wire bond 24 o the gate contact 16c.

After that, the module 44" is moulded and the bonding areas 20 of the chips 12 are soldered or sintered as described above.

In the end, further connections may be provided by clamping the module 44' between cooler plates with TIM, soldering, etc.

As shown in Fig. 15, the second substrate 46 may be a thin flexible lead frame, for example for low voltage applications.

As shown in Fig. 16, the second substrate 46 may be a massive emitter contact, for example for high voltage applications.

As shown in Fig. 17, an electrically conducting aluminium metal plate 54 may be bonded to the bonding area 20 of the semiconductor devices 12. The metal plate 54 (which may be a preform) may be shaped to fit exactly into the openings 34. It is possible that the metal plate 54 is soldered or sintered to the chip 12 and/or that the second substrate 46 is sintered and or soldered to the metal plate 54. The metal plate 54 may provide SCFM capability to the module 44".

The benefits of the module 44" may be: SCFM capable in case an Al metal plate 54 is bonded on top of semiconductor device 12, semi-hermetic, high reliability, low cost, modular approach (stacking or paralleling) and efficient double side cooling.

Further alternative embodiments for the embodiments shown in the above figures are:

A flexible circuit board may be sintered as second substrate 46 on top of the bonding areas 20, 22 for the emitter and the gate, wherein the flexible circuit board comprises paths/vias (contacts) for both the emitter and the gate.

A lead frame as second substrate 46 is provided with gate contacts 16b and emitter contacts 16c. In order to provide an insulation, the lead frame 46 is moulded with the same moulding material as used for the moulding of the first substrate 10 and the semiconductor devices 12. The moulded second substrate 46 and the moulded first substrate 10 with the semiconductor devices 12 are contacted with the sintering process.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

**List of references**

| | |
|---|---|
| 10 | first substrate |
| 12 | semiconductor device |
| 14 | insulator |
| 16 | metallization layer |
| 16a | emitter contact |
| 16b | gate contact |
| 16c | collector contact |
| 18 | bonding area |
| 20 | bonding area |
| 22 | bonding area |
| 24 | wire bond |
| 26 | mould tool |
| 28 | protrusion |
| 30 | constraints |
| 32 | moulding material |
| 34 | opening |
| 36 | outer surface |
| 38 | bonding material |
| 40 | dispensing device |
| 42 | frame |
| 44, 44', 44" | electronics module |
| 46 | second substrate |
| 46a, 46b | lead frame |
| 48 | protrusion |
| 50 | contact area |
| 52 | opening |
| 54 | metal plate |

## Claims

1. A method for producing an electronics module (44, 44', 44"), the method comprising the steps of:
bonding a semiconductor device (12) to a first substrate (10);
moulding the semiconductor device (12) and the first substrate (10) into a moulding material (32), such that the semiconductor device (12) and the first substrate (10) are at least partially covered by the moulding material (32) and such that the moulding material (32) comprises an opening (34) to a bonding area (20) of the semiconductor device (12);
positioning a second substrate (46) opposite to the first substrate (10) with respect to the semiconductor device (10);
bonding the second substrate (46) to the bonding area (20) of the semiconductor device (12).

2. The method of claim 1, further comprising the step of:
protecting the bonding area (20) of the semiconductor device (12) with a plastic film (33) before the moulding.

3. The method of claim 1 or 2, further comprising the step of:
applying a bonding material (38) into the opening (34) before the bonding of the second substrate (46).

4. The method of claim 3,
wherein the bonding material (38) is a sintering material and the bonding of the second substrate (46) is performed by sintering the second substrate (46) to the semiconductor device (12).

5. The method of claim 3,
wherein the bonding material (38) is a soldering material and bonding of the second substrate (46) is performed by soldering the second substrate (46) to the semiconductor device (12).

6. The method of one of the preceding claims,
wherein the moulding material (32) forms a frame (42) around the opening (34), such that the opening (34) forms a deepening for receiving a bonding material (38).

7. The method of one of the preceding claims,
wherein the moulding material (32) covers the semiconductor device (12) such that dedicated areas of the semiconductor device (12) cannot come into contact with bonding material (38) during the bonding of the semiconductor device (12) to the second substrate (46).

8. The method of one of the preceding claims,
wherein the first substrate (10) is a lead frame, PCB or metallized ceramics; and /or
wherein the second substrate (46) is a lead frame, PCB or metallized ceramics.

9. The method of one of the preceding claims, further comprising the step of:
soldering or sintering the semiconductor device (12) to the first substrate (10).

10. The method of one of the preceding claims, further comprising the step of:
attaching an electrically conducting metal plate (54) and/or applying a metallic layer to the bonding area (20) of the semiconductor device (12).

11. The method of one of the preceding claims, further comprising the step of:
electrically connecting the semiconductor device (12) to the first substrate (10) via a wire bond (24);
wherein the wire bond (24) is encased into the moulding material (32) during the moulding.

12. The method of one of the preceding claims,
wherein a plurality of semiconductor devices (12) are attached to the first substrate (10), moulded into one moulding material (32).

13. The method of one of the preceding claims, further comprising the step of:
structuring the second substrate (46) such that the second substrate has a protrusion (48) fitting into the opening in the moulding material.

14. An electronics module (44, 44', 44"), comprising:
a semiconductor device (12);
a first substrate (10), wherein the semiconductor device (12) is bonded with a first side to the first substrate (10);
a moulding material (32), wherein the semiconductor device (12) and the first substrate (10) are moulded into the moulding material (32), such that the semiconductor device (12) and the first substrate (10) are at least partially encased in cured moulding material (32) and such that the cured moulding material (32) comprises an opening (34) to a bonding area (20) of the semiconductor device (12);
a second substrate (46), wherein the second substrate (46) is positioned opposite to the first substrate (10) with respect to the semiconductor device (12) and bonded through the opening (34) in the moulding material (32) to a second side of the semiconductor device (12).
